# EUROPÄISCHE PATENTSCHRIFT

(11) **EP 2 867 684 B1**
(45) Veröffentlichungstag und Bekanntmachung des Hinweises auf die Patenterteilung: **26.12.2018**
(21) Anmeldenummer: 13732159.2
(22) Anmeldetag: 27.06.2013
(51) Int. Cl.: G01R 1/04, G01R 19/00, G01R 15/20

(54) **ANORDNUNG ZUR STROMMESSUNG**
ARRANGEMENT FOR MEASURING CURRENT
SYSTÈME DE MESURE DU COURANT

(30) Priorität: 27.06.2012 DE 102012012759
(43) Veröffentlichungstag der Anmeldung: 06.05.2015
(73) Patentinhaber: Sensitec GmbH, 35633 Lahnau (DE)
(72) Erfinder: SCHMITT, Jochen, 35216 Biedenkopf (DE)
(74) Vertreter: Spachmann, Holger
(86) Internationale Anmeldenummer: PCT/EP2013/063557
(87) Internationale Veröffentlichungsnummer: WO 2014/001473

(56) Entgegenhaltungen:
- DE-A1- 4 300 605
- DE-A1-102006 021 774
- US-A1- 2007 188 946
- US-A1- 2008 258 721

## Beschreibung

Die vorliegende Erfindung betrifft eine Anordnung zur indirekten Messung eines Stromes in einem Leiter durch die Erfassung des den stromführenden Leiter umgebenden Magnetfeldes.

### STAND DER TECHNIK

Derartige Anordnungen sind aus dem Stand der Technik bekannt. So ist in der DE4300605 eine Anordnung beschrieben, bei der ein Sensorchip in einer Gradiometeranordnung ausgestaltet ist und auf einem U-förmigen Leiterelement montiert wird. Dabei wird ausgenutzt, dass die beschriebene Gradiometeranordnung für homogene Störfelder am Ort des Sensorelementes weitestgehend unempfindlich ist. Um möglichst geringe inhomogene Störfelder durch Ströme durch den Verbindungssteg zwischen den Schenkeln des U-Leiters oder der Zuführung zum U-Leiter am Ort des Sensors zu erzeugen, wird die Länge der Schenkel des U-förmigen Leiters in der Regel groß gegenüber der Ausdehnung der magnetfeldempfindlichen Elemente auf dem Sensorchip gewählt.

Weiterhin sind in derartigen Anordnungen, insbesondere bei Sensoren die den anisotropen magnetoresistiven Effekt (AMR-Effekt) ausnutzen, Hilfsmagnete in der Nähe zu den magnetfeldempfindlichen Schichten vorhanden, welche für eine Stabilisierung bzw. Basismagnetisierung der magnetfeldempfindlichen Schichten auf dem Sensorchip sorgen. Mit einer zunehmenden Miniaturisierung einer derartigen Sensoranordnung können die Störfeldanteile z.B. durch die Ströme in dem Verbindungssteg zwischen den Schenkeln des U-Leiters eine Größe annehmen, die zu einer Veränderung oder zum "Umkippen" der Magnetisierung der magnetfeld-empfindlichen Schichten führt. Dies führt zu gravierenden Fehlern in der Strommessung und muss daher vermieden werden.

In der DE 10 2006 021 774 A1 ist eine Stromsensoranordnung mit XMR-Sensorelemente beschrieben, die in einer, einem strommessaktiven Leiterabschnitt zugeordneten Empfindlichkeitsrichtung empfindlich und einem strommessparasitären Leiterabschnitt unempfindlich ist. In einer Anordnung ist erkennbar, dass ein strommessparasitärer Leiterabschnitt ein Magnetfeld bewirkt, das rechtwinklig zur Empfindlichkeitsrichtung des Sensorelements ausgerichtet ist.

Aus der US 2007/188946 A1 ist eine Stromsensoranordnung bekannt, die ein zweischenkliges, gegeneinander um 90° abgewinkeltes, und stromdurchflossenes Leiterelement umfasst, an dessen beiden Schenkeln als Leiterabschnitte jeweils ein magnetfeldempfindliches Sensorelement angeordnet ist. Die Sensorelemente der beiden Schenkel sind gegeneinander verdreht, um den Einfluss des Magnetfelds des jeweilig anderen Schenkels zu minimieren.

Weiterhin sind gattungsähnliche Stromsensoranordnung aus der DE 43 00 605 A1 und der US 2997/258721 A1 bekannt.

Ausgehend von dem oben genannten Stand der Technik ist es die Aufgabe der Erfindung, die Nachteile der bekannten Anordnungen und Verfahren zu verringern.

Die oben genannten Nachteile werden durch eine Vorrichtung nach Anspruch 1 gelöst. Vorteilhafte Weiterbildungen der Erfindung sind Gegenstand der abhängigen Ansprüche.

### OFFENBARUNG DER ERFINDUNG

In einem ersten Aspekt wird eine Anordnung zur magnetfeldbasierten Messung von elektrischen Strömen mittels mindestens einem magnetfeldempfindlichen Sensorelement in einem abgewinkelten, insbesondere U-förmigen Leiterelement vorgeschlagen, das zumindest einen strommessaktiven Leiterabschnitt und zumindest einen strommessparasitären Leiterabschnitt umfasst. Das Sensorelement ist derart im Bereich des strommessaktiven Leiterabschnitts angeordnet, dass das Magnetfeld des strommessaktiven Leiterabschnitts eine hohe Sensorwertveränderung, insbesondere eine hohe Widerstandsveränderung hervorruft, und das Magnetfeld des strommessparasitären Leiterabschnitts aufgrund der räumlichen Ausrichtung des Sensorelements gegenüber dem strommessparasitären Leiterabschnitt und/oder durch Feldkompensationseffekte weiterer stromführender Elemente geringe, im Wesentlichen keine Sensorwertveränderung hervorruft. Somit betrifft die Erfindung eine Strommessanordnung auf der Basis einer Magnetfeldmessung, bei dem ein Sensorelement an einem Leiterabschnitt eines Stromleiters derart räumlich angeordnet ist, dass parasitäre Magnetfelder, die durch Leiterabschnitte hervorgerufen werden, die nicht dem zu messenden Leiterabschnitt entsprechen, das Sensorelement nicht durchsetzen oder in einer Richtung durchsetzen, in dem sie im Sensorelement keine Sensorwertveränderung hervorrufen. Die Anordnung wird durch ein Verkippen einer Empfindlichkeitsrichtung des Sensorelements gegenüber einer Stromleitrichtung von strommessparasitären Leiterabschnitten (Zuführungsleiterabschnitten), und/oder ein Versetzen von Höhenebenen einer Lage von magnetfeldempfindlichen Sensorstrukturen gegenüber einem konzentrierten Linienstrom durch die parasitären Leiterabschnitten definiert. Die vorgenannten Maßnahmen der Winkelverkippung und Höhenversetzung und Magnetfeldkompensation können einzeln oder in Kombination angewendet werden. Durch diese Maßnahmen wird gewährleistet, dass parasitäre Magnetfeldkomponenten zum einen interne Magnetisierungszustände von Widerstandselementen von Sensorstrukturen negativ beeinflussen, zum anderen keinen Einfluss auf die Sensorwertveränderung / Widerstandswertveränderung ausüben, um ein lineares und zuordenbares Sensorwertverhalten zu erreichen.

Erfindungsgemäß weist das Sensorelement zumindest eine Empfindlichkeitsrichtung auf, in der Magnetfeldkomponenten eine hohe Sensorwertveränderung bewirken, wobei das Sensorelement derart im Bereich des strommessaktiven Leiterabschnitts ausgerichtet, insbesondere gegenüber dem strommessparasitären Leiterabschnitt verdreht, verkippt und/oder höhenversetzt ist, so dass das Magnetfeld des strommessaktiven Leiterabschnitts im Wesentlichen in Empfindlichkeitsrichtung und das Magnetfeld des strommessparasitären Leiterabschnitts im Wesentlichen nicht in Empfindlichkeitsrichtung, insbesondere rechtwinklig zur Empfindlichkeitsrichtung ausgerichtet ist. Somit wird ein magnetoresistives Sensorelement betrachtet, dass zumindest eine magnetfeldsensitive Ausrichtungsebene mit einer Empfindlichkeitsrichtung als Normale aufweist, die beim Durchsetzen eines magnetischen Flusses in Empfindlichkeitsrichtung eine Sensorwertänderung, in der Regel eine Widerstandsänderung des Sensorelements bewirkt. Zumindest eine weitere, magnetfeldneutrale Ausrichtungsebene des Sensorelements, deren Normale in der Regel rechtwinklig zur Empfindlichkeitsrichtung ausgerichtet ist, ist für eine Magnetfeldänderung unempfindlich. Magnetfelder, die normal durch die magnetfeldneutrale Ausrichtungsebene treten, verändem den Sensorwert, insbesondere einen Widerstandswert des Sensorelements nicht.

Es wird vorgeschlagen, dass die Empfindlichkeitsrichtung durch eine räumliche Positionierung des Sensorelements gegenüber den strommessparasitären Leiterabschnitten derart ausgerichtet werden, dass die Überlagerung aller parasitären Magnetfelder gerade nicht in Empfindlichkeitsrichtung ausgerichtet ist, d.h. normal durch eine magnetfeldneutrale Ausrichtungsebene treten, und somit keine oder eine nur geringe Sensorwertveränderung hervorrufen kann. Hierdurch wird erreicht, dass lediglich die vom strommessaktiven Leiterabschnitt, insbesondere einem bzw. beiden Schenkeln eines U-förmigen Leiterelements hervorgerufenen Magnetfelder eine Sensorwertänderung hervorrufen.

In einer vorteilhaften Ausführungsform kann das mindestens eine magnetfeldempfindliche Sensorelement gekippt zu dem Sensorelement zugeordneten Leiterelement angeordnet sein. Dabei wird ausgenutzt, dass die magnetfeldempfindlichen Strukturen des Sensorelementes nur auf Magnetfelder in einer oder zwei Raumrichtungen empfindlich sind, d.h. Magnetfelder, die zu diesen bevorzugten Magnetfeldrichtungen senkrecht stehen, werden von den magnetfeldempfindlichen Strukturen nicht erfasst.

Als magnetfeldempfindliche Sensorelemente werden dabei vorteilhaft magnetoresistive Sensorelemente eingesetzt, die zum Beispiel nach dem AMR-Effekt (Anisotropic Magnetic Resistance) oder GMR-Effekt (Giant Magnetic Resistance) oder TMR-Effekt (Tunnel-Magnetic Resistance) arbeiten. Gleichermaßen können auch Sensorelemente, die den Hall-Effekt nutzen, eingesetzt werden. In der Regel weisen AMR-, TMR- und GMR-Sensoren eine Empfindlichkeitsrichtung auf, die in der Ebene der Sensorstruktur, in der Regel in der Chipebene liegt, in den meisten Fällen rechtwinklig zu einer Stromrichtung durch die Sensorstrukturen und rechtwinklig zur Normalen der Anordnungsebene der Sensorstrukturen. Hall-basierte Sensoren weisen in den meisten Fällen eine Empfindlichkeitsrichtung senkrecht zur Anordnungsebene der Sensorstruktur auf.

Das mindestens eine Sensorelement kann vorteilhaft so gekippt gegenüber dem U-förmigen Leiterelement angeordnet werden, dass der Einfluss des Magnetfeldes, welches durch Ströme im Verbindungssteg zwischen den beiden Schenkeln des U-förmigen-Leiterelementes erzeugt wird, minimiert wird. Dies wird vorteilhaft so gelöst, dass das mindestens eine Sensorelement so positioniert wird, dass die in der Empfindlichkeitsrichtung des Sensorelementes liegenden Komponenten des Magnetfeldes welches durch Ströme im Verbindungssteg zwischen den beiden Schenkeln des U-förmigen-Leiterelementes erzeugt wird, am Ort des Sensorelementes minimiert sind. In Dünnschichttechnik hergestellte AMR- Sensorelemente nach Stand der Technik sind beispielsweise unempfindlich gegenüber Magnetfeldkomponenten, die senkrecht zur Sensorebene auftreffen. In einem derartigen Ausführungsbeispiel würde der Kippwinkel so gewählt, dass störende Magnetfelder senkrecht auf das mindestens eine AMR-Sensorelement auftreffen werden. Wird die Lage bzw. der Abstand des Sensorelementes zum U-förmigen Leiterelement verändert, so ist auch der jeweils optimale Kippwinkel wieder so anzupassen, dass die störenden Magnetfelder wiederum keine Komponenten in der Empfindlichkeitsrichtung des Sensorelementes aufweisen. Da der Abstand des Sensorelementes auch die resultierende Messempfindlichkeit der Anordnung verändert, kann eine Optimierung von Lage und optimalen Kippwinkel aufgrund der Anforderungen an Empfindlichkeit, evtl. notwendiger Isolationsabstände und den resultierenden Abmessungen der Anordnung erfolgen. Vorteilhaft liegt der Betrag des Kippwinkels α im Bereich 0 < |α| < 120 °. Eine weitere Vergrößerung des Kippwinkels würde zu einer Vergrößerung der resultierenden Abmessungen über die Ausdehnung des Leiterelementes hinaus führen, was in vielen Anwendungen ja gerade vermieden werden soll.

Neben dem durch Ströme im Verbindungssteg zwischen den beiden Schenkeln des U-förmigen-Leiterelements erzeugten Magnetfeld können auch die Magnetfelder die Messgenauigkeit negativ beeinflussen, die durch Ströme durch die Anschlussleitungen zum U-förmigen Leiterelement erzeugt werden. Besonders vorteilhaft kann der Kippwinkel daher in einem weiteren Ausführungsbeispiel so gewählt werden, dass auch die Überlagerung der Magnetfelder des Verbindungssteges und der Anschlussleitungen am Ort des Sensorelementes nur minimale Anteile in Empfindlichkeitsrichtung des Sensorelementes liefert.

In einem weiteren vorteilhaften Ausführungsbeispiel kann das mindestens eine Sensorelement ein Gradientensensor sein, so dass die Anordnung gegenüber externen homogenen störenden Magnetfeldern weitestgehend unempfindlich ist. Es ist jedoch auch möglich, dass mehrere, jeweils das Absolutfeld messende Sensorelemente vorgesehen sind, bei denen eine zusätzliche Auswerteelektronik die Ausgangssignale der Sensorelemente in geeigneter Weise zusammenführt. Durch die Anordnung von einer Vielzahl von das Absolutfeld messenden Sensorelementen kann insbesondere erreicht werden, dass eine optimale Unterdrückung von Störeffekten erfolgt. Der optimale Kippwinkel kann sich dabei für die verschiedenen Sensorelemente auch unterschiedlich ergeben.

Besonders vorteilhaft kann das U-förmigen-Leiterelement der Anordnung dadurch ausgeformt sein, dass in einem flachen geraden Leiterstück entsprechende Schlitze eingebracht werden. Derartige gerade Stromleiter mit U-förmiger Teilstruktur weisen hinsichtlich ihrer Abmessungen und der Einfachheit in der Herstellung Vorteile auf.

Für eine kompakte, platzsparende Variante und der Anordnung des Sensorelements mit zwei magnetfeldempfindlichen Sensoreinheiten, insbesondere magnetfeldsensitiven Widerständen, die in einer Wheatstone-Messbrücke einschaltbar sind, auf einer gemeinsamen Grundplatte, insbesondere einem Chipsubstrat oder einem PCB zu ermöglichen, ist es vorteilhaft, dass die beiden Schenkel des U-förmigen Leiterelements parallel und in geringem Abstand zueinander angeordnet sind. Somit können magnetfeldempfindliche Sensoreinheiten in einem kompakten Bauteil, dessen Grundfläche beide Schenkel zumindest teilweise überdeckt, angeordnet, sein. Ein derartiges Bauteil kann durch ein Befestigungsmittel, beispielsweise ein Rast- oder Schnappelement an beiden Schenkeln gleichzeitig befestig werden. Ein derart kompaktes Sensorelement, das beide Schenkel des U-förmigen Leiterelements überdeckt, ist kostengünstig herstellbar und einfach montierbar, wobei die Gesamtgröße der Magnetfeldmessanordnung geringe Abmessungen aufweist. In einer weiteren vorteilhaften Ausführung kann ein Befestigungsmittel vorgesehen sein, auf dass das mindestens eine Sensorelement montiert ist und somit das mindestens eine Sensorelement in einer gekippten, verdrehten und/oder höhenversetzten Lage in Bezug auf das zugeordnete Leiterelement fixiert ist. Das Befestigungsmittel kann insbesondere so gestaltet werden, dass es zur Vereinfachung der Montage und Einhaltung der zulässigen Toleranzen am oder im Leiterelement einrastet oder mit angepassten Montage- oder Justage-Hilfsmitteln ausgestattet ist, welche eine exakte Positionierung am zugeordneten Leiterelement ermöglichen. Beispielsweise können Führungsrillen oder Justagestifte vorgesehen sein, die eine exakte Montage relativ zum Stromsensorelement ermöglichen. Vorteilhaft ist das Befestigungsmittel aus einem Kunststoff gefertigt, bzw. weist Elemente auf, die aus einem Kunststoff bestehen. Hierdurch kann das Befestigungsmittel werkzeugfrei am Leiterelement befestigt und bei Defekt auch abgelöst werden.

Des Weiteren kann das Befestigungsmittel zumindest eine elektrische Leiterbahn aufweisen, welche das mindestens eine Sensorelement elektrisch kontaktiert. Somit entfallen zusätzlicher Verdrahtungsaufwand, da die Leiterbahn bereits in dem Befestigungsmittel umfasst ist. Die Leiterbahnen sind dabei definiert verlegbar und können derart angeordnet sein, dass deren Magnetfelder keinen parasitären Einfluss auf die Magnetfeldmessung haben, bzw. dass deren parasitäre Magnetfelder sich gegenseitig kompensieren. So können Zuführungsleitungen nach einem Twisted-Pair Prinzip im Befestigungsmittel geführt sein. Neuartige Technologien, die so genannte MID-Technologie (MID = Molded Interconnect Devices) erlaubt es, ein Kunststoffelement mit zusätzlichen Leiterbahnen zu versehen, die eine elektrische Kontaktierung von elektrischen Komponenten, die auf dem Kunststoff montiert sind, ermöglichen. In einem weiteren Ausführungsbeispiel weist daher das Befestigungsmittel zusätzliche Leiterbahnen auf, mit dem das mindestens eine Sensorelement kontaktiert wird. Das mindestens eine Sensorelement kann dabei beispielsweise mittels Bondtechnologie oder durch eine Lötverbindung mit den Leiterbahnen des Befestigungsmittels kontaktiert werden.

In einer weiteren vorteilhaften Ausführungsform kann die Anordnung zusätzliche Bauelemente aufweisen, die beispielsweise für die Aufbereitung der Sensorsignale erforderlich sind. Auch diese zusätzlichen Bauelemente können auf dem Befestigungsmittel montiert werden, wobei die elektrische Verbindung zwischen den Bauelementen und mindestens einem Sensorelement beispielsweise mittels MID-Technologie oder einer Bondtechnologie hergestellt wird.

Eine vorteilhafte Anordnung kann auch zusätzliche Anschlusselemente, zum Beispiel einen Steckverbinder aufweisen, mit dem die Sensoranordnung elektrisch kontaktiert werden kann. Dieser Steckverbinder kann in einer weiteren Ausführungsform am Befestigungsmittel montiert sein. Das Herstellen der elektrischen Verbindung zu evtl. vorhandenen Bauelementen und/oder dem mindestens einen Sensorelement kann in einer ähnlichen wie zuvor beschriebenen Art und Weise z.B. durch Bonden oder Löten erfolgen.

Es ist jedoch auch möglich, dass ein zusätzlicher Schaltungsträger vorgesehen ist, der eine oder mehrere zuvor genannte Komponenten aufnimmt, eventuelle elektrische Verbindungen zwischen den Komponenten herstellt und als Einheit auf dem Befestigungsmittel montiert wird. Auch weitergehende Ausführungsformen, bei denen Komponenten teilweise direkt auf dem Befestigungsmittel montiert sind und zusätzliche Schaltungsträger vorgesehen sind, die auf dem Befestigungsmittel montiert werden, sind denkbar.

Zum Schutz vor mechanischen Einflüssen, zum Beispiel vor Verschmutzung, Feuchtigkeit oder zur Vermeidung von unzulässiger mechanischer Belastung kann in einer weiteren vorteilhaften Ausführungsform einer Umhüllung der Elemente der Sensoranordnung erfolgen. Von Vorteil ist eine Umhüllung, welche gleichzeitig den zugehörigen Stromleiter umfasst. Die Kontakte eines eventuell vorgesehenen Steckverbinders zur Kontaktierung der Einheit können dabei von der Umhüllung ausgespart werden.

Gemäß einer vorteilhaften Ausführungsform kann die dreidimensionale räumliche Anordnung von Sensorelement und strommessparasitärem Leiterabschnitt derart zueinander gestaltet sein, so dass eine magnetfeldneutrale Ausrichtungsebene des Sensorelements, deren Normale rechtwinklig zur Empfindlichkeitsrichtung steht, senkrecht zu einer Tangente einer geschlossenen Magnetfeldlinie des durch die Stromverteilung des strommessparasitären Leiterabschnitts erzeugten parasitären Magnetfeldes ausgerichtet ist. Mit anderen Worten schlägt diese Ausführungsform vor, die magnetfeldneutrale Ausrichtungsebene, in vielen Fällen die Ebene, in der die Sensorstrukturen des Sensorelements eingebettet sind, in einer Höhe und Ausrichtwinkel auszurichten, so dass parasitäre Magnetfelder rechtwinklig diese Ebene durchsetzen. Somit weisen parasitäre Magnetfelder keine Komponenten auf, die innerhalb der magnetfeldneutralen Ausrichtungsebene, insbesondere in Empfindlichkeitsrichtung liegen, so dass diese weder eine Sensorempfindlichkeit beispielsweise durch Störung einer inneren Magnetisierung der Sensorstrukturen beeinträchtigen, noch Komponenten in die magnetfeldsensitive Empfindlichkeitsrichtung ausbilden.

Vorzugsweise kann das Leiterelement ein metallisches Stanzbiegeteil sein, und der Schwerpunkt der Stromdichteverteilung durch die strommessparasitären Leiterabschnitte und eine magnetfeldneutrale Ausrichtungsebene, dessen Normale rechtwinklig zur Empfindlichkeitsrichtung ist, am Ort des Sensorelements können im Wesentlichen auf der gleichen Höhenebene z liegen. Alternativ oder in Kombination kann das Sensorelement auf einem gebogenen strommessaktiven Leiterabschnitt angeordnet sein, wodurch der strommessparasitäre Leiterabschnitt und eine magnetfeldneutrale Ausrichtungsebene, dessen Normale rechtwinklig zur Empfindlichkeitsrichtung ist, am Ort des Sensorelements im Wesentlichen auf der gleichen Höhenebene z liegen. Die vorgenannten Varianten zur Ausbildung eines Höhenunterschieds zwischen strommessparasitären Leiterabschnitten eines Verbindungssteges und strommessaktiven Leiterabschnitten eines Schenkels eines U-förmigen Stromleiterelements dienen dazu, dass eine magnetfeldneutrale Ausrichtungsebene in etwa der Höhe eines konzentrierten Linienstroms, der in dem strommessparasitären Leiterabschnitts fließt, angeordnet ist. Somit liegt der Zuführlinienstrom faktisch in der gleichen Ebene wie die magnetfeldneutrale Ausrichtungsebene, so dass die parasitären Magnetfelder im Wesentlichen rechtwinklig diese Ausrichtungsebene durchdringen und keinen nachteiligen Effekt auf die Magnetfeldmessung haben. Die magnetfeldsensitive Ausrichtungsebene wird somit nur von Magnetfeldern des strommessaktiven Leiterabschnitts des Schenkels durchsetzt, der in der z-Ebene versetzt zur Ebene des Zuführlinienstroms und der magnetfeldneutralen Ausrichtebene des Sensorelements liegt.

In einer weiterführenden Ausführungsform wird eine höhenversetzte Anordnung von strommessaktiven und strommessparasitären Leiterabschnitten auf oder in einer PCB-Struktur, insbesondere in einem Mehrlagen-PCB (Printed Circuit Board) auf verschiedenen Layern vorgeschlagen. Hierzu kann vorteilhafterweise das Sensorelement auf einem Layer des Mehrlagen-PCB, bevorzugt auf demselben Layer wie die strommessparasitären Leiterabschnitte angeordnet sein. Die Leiterstrukturen, die die strommessparasitären Leiterabschnitte definieren, insbesondere Stromzuführungsleitungen und Stromabführleitung, sowie Verbindungssteg zwischen zwei Leitungsschenkel können auf einer ersten Metallisierungsebene eines Mehrlagen-PCBs angeordnet sein, wobei auf dieser Ebene ebenfalls das Sensorelement angeordnet sein kann. Auf einer weiteren, höhenversetzten Ebene können die strommesssensitiven Leiterabschnitte, insbesondere die Schenkel einer U-förmigen Leiterstruktur als weiterer Metallisierungslayer angeordnet sein. Die Leiterabschnitte der Ebenen können durch Vias bzw. Durchkontaktierungen verbunden sein. Auf der PCB-Struktur können weitere Bauteile, Kompensationsmagnete bzw. Kompensationsmagnetfeldspulen und/oder Elektronikkomponenten angeordnet sein. Insbesondere können Auswerte- und/oder Anzeigeelemente und/oder Anschlussschnittstellen, d.h. Stecker-/Kupplungselemente auf dem PCB angeordnet werden, um ein kompaktes Bauteil bereitzustellen Die Herstellung der PCB-Lagen kann in üblichen PCB-Produktionsverfahren erfolgen, so dass eine kostengünstige Herstellung mit hoher Fertigungsgenauigkeit erreicht werden kann. Die PCB-Struktur versteift die Strommessanordnung, so dass diese als mechanisch stabiles Bauteil hergerichtet ist.

Weitere Vorteile, Merkmale und Einzelheiten der Erfindung ergeben sich aus den im Folgenden beschriebenen Ausführungsbeispielen sowie anhand der Zeichnungen. Im Einzelnen zeigen die Zeichnungen:
- Fig. 1: Anordnung mit U-förmigem Stromleiter gemäß Stand der Technik;
- Fig. 2: Darstellung der Magnetfeldrichtungen eines stromdurchflossenen U-förmigen Leiters gemäß Stand der Technik;
- Fig. 3: Darstellung der Magnetfeldlinien eines stromdurchflossenen U-förmigen Leiters mit verkürzter Schenkellänge;
- Fig. 4: Schemaskizze eines Sensorelements mit einer magnetfeldsensitiven und zwei magnetfeldneutralen Ausrichtungsebenen;
- Fig. 5: Darstellung der resultierenden Magnetfeldvektoren und der Magnetfeldlinien bei vorhandenem Hilfsfeld;
- Fig. 6: Anordnung eines Gradientensensors bei einem geraden Stromleiterelement;
- Fig. 7: Schnittdarstellung bezüglich Fig. 6 mit Darstellung eines optimalen Kippwinkels;
- Fig. 8: Erfindungsgemäßes Ausführungsbeispiel mit einem auf dem Stromleiter montierten Befestigungsmittel;
- Fig. 9: Schnittdarstellung von Sensoranordnungs-Ausführungsformen mit verschiedenen dreidimensionalen Anordnungen von strommessaktiven zu strommessparasitären Leiterabschnitten;
- Fig. 10: Ausführungsform einer Sensoranordnung mit einem Stromleiter als Stanzbiegeteil;
- Fig. 11: Weiteres Ausführungsbeispiel mit zusätzlich montierten Bauelementen;
- Fig. 12: Weiteres Ausführungsbeispiel eines Stromleiters mit Umhüllung;
- Fig. 13: Ausführungsbeispiel einer Sensoranordnung mit mehreren Sensorelementen;
- Fig. 14: Ausführungsbeispiel einer Sensoranordnung mit mehreren um einen Winkel α gekippten Sensorelementen.

### AUSFÜHRUNGSFORMEN DER ERFINDUNG

In den Figuren sind gleiche oder gleichartige Komponenten mit gleichen Bezugszeichen beziffert. Die dargestellten Figuren sind nicht maßstabsgerecht und dienen lediglich der schematischen und prinzipiellen Darstellung der verschiedenen Sensoranordnungen.

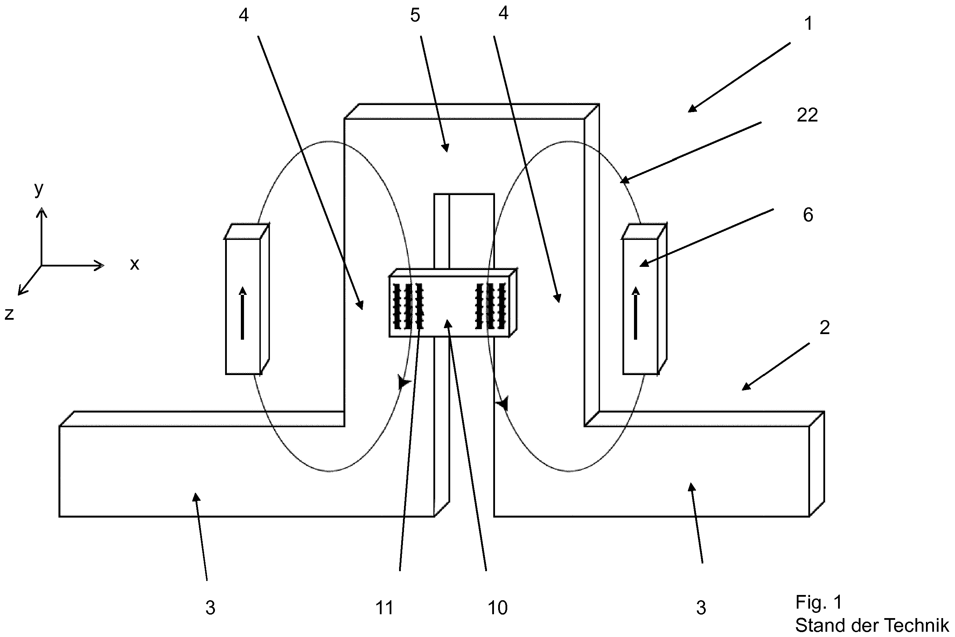

In der Figur 1 ist eine Anordnung zum Messen von elektrischen Strömen gemäß Stand der Technik gezeigt. Die Anordnung 1 besteht aus einem in der x-y-Ebene liegenden Stromleiter 2, der die Anschlussleitungen 3, die Schenkel 4 und den Verbindungssteg 5 aufweist, sowie aus einem Sensorelement 10, das in einer Ebene parallel zum Stromleiter 2 angeordnet ist. Das Sensorelement 10 weist dabei zwei voneinander entfernt liegende Sensorstrukturen 11 auf, die eine Messung des Gradienten-Magnetfeldes ermöglichen, welches von einem Strom in dem U-förmigen Leiter 2 erzeugt wird. Zur Stabilisierung der Sensorstrukturen 11 weist die Anordnung zwei Permanentmagnete 6 auf, die ein Hilfs-Magnetfeld 22 im Bereich der Sensorstrukturen 11 erzeugen. Die Sensorstrukturen können zum Beispiel magnetoresistive Widerstands-Elemente beinhalten, deren elektrischer Widerstand sich in Abhängigkeit von in der x-yEbene liegenden Magnetfeldkomponenten ändert.

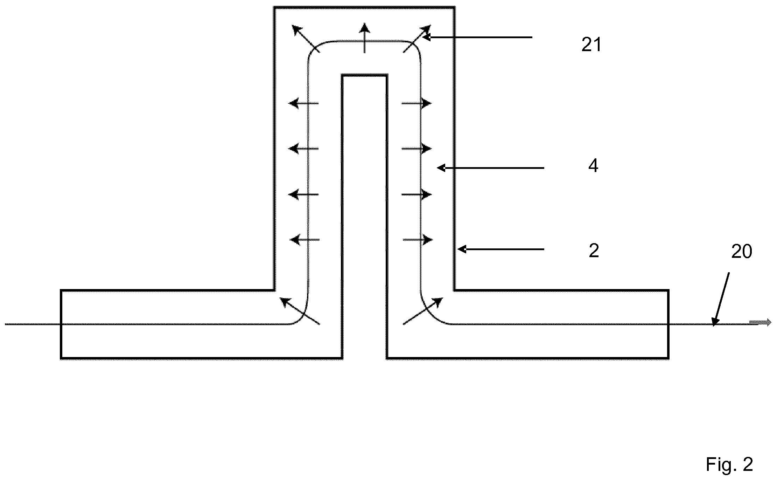

In Figur 2 ist ein Strom 20 angedeutet, der in dem U-förmigen Stromleiterelement 2 fließt und dabei ein Magnetfeld entsprechend der eingezeichneten Pfeilrichtungen 21 auf der Oberfläche des Stromleiters erzeugt. Gut zu erkennen ist, dass die Magnetfeldrichtungen im Bereich der Schenkel 4 eine jeweils entgegengesetzte Richtung aufweisen, so dass gemäß dem Stand der Technik eine Gradientenmessung mittels eines geeigneten Sensorelementes 10 in diesem Bereich möglich ist.

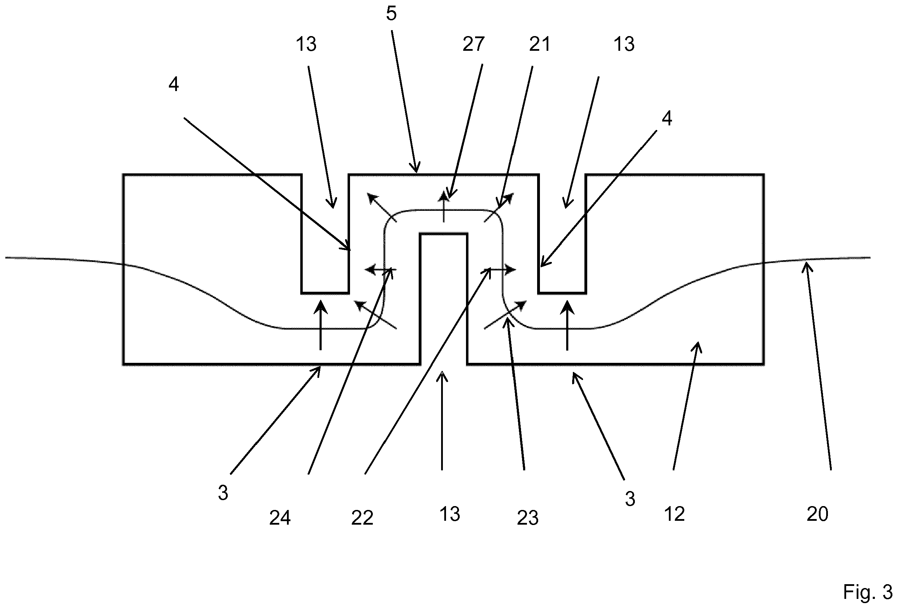

In Figur 3 ist ein gerader Stromleiter 12 gezeigt, bei dem durch Einbringen von Schlitzen 13 eine U-förmige Teilstruktur 2 gebildet ist. Entsprechend Figur 2 ist ein Strom 20 angedeutet, der ein resultierendes Magnetfeld mit den beispielhaften Feldlinien 21, 22, 23, 24 erzeugt. Gut zu erkennen ist, dass im Bereich der Schenkel 4 wiederum Magnetfeldgradienten erzeugt werden, wobei aufgrund der räumlichen Nähe eine Beeinflussung durch die Magnetfelder z.B. mit den Feldvektoren 21 und 23 zu erwarten ist. Daneben werden insbesondere im Bereich des Verbindungssteges 5 und der Anschlussleitungen 3 Magnetfelder erzeugt, deren Feldrichtung rechtwinklig zu den Magnetfelder 22 und 24 im Bereich der Schenkel 4 liegt. Insbesondere Magnetfelder des Verbindungssteges 5 wirken sich parasitär auf den Sensorkennwert aus.

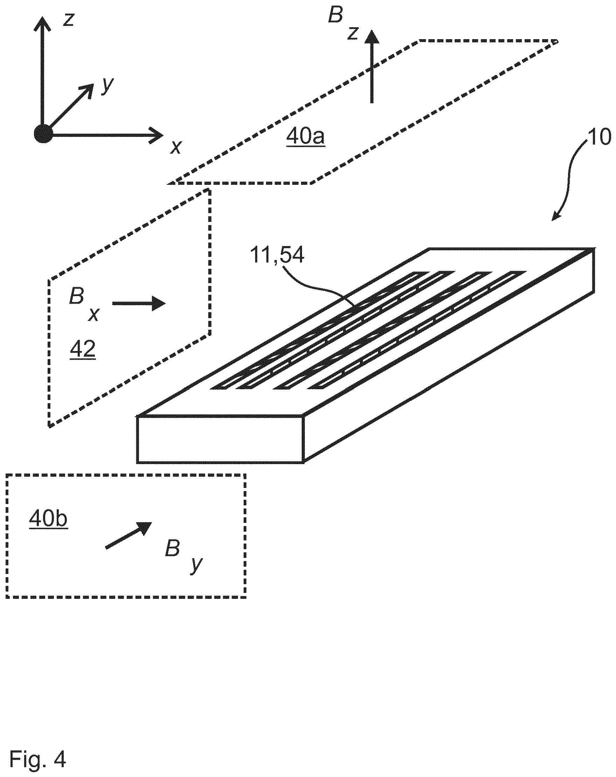

Die Fig. 4 stellt in einer schematischen perspektivischen Darstellung ein Sensorelement 10 mit vier Sensorstrukturen 11 dar, die als magnetoresistive AMR-Widerstandsstreifen 54 (anisotrope magnetoresistive Widerstandsstreifen) ausgebildet sind. Die Widerstandsstreifen können bevorzugt in einer Wheatstone-Messbrücke als Widerstand eines oder zweier Teilzweige eingeschaltet sein. Die Lage und Ausrichtung der Widerstandsstreifen 54 definieren auf der Oberfläche eines Substrats zwei magnetfeldneutrale Ausrichtungsebenen 40a und 40b, die zur Übersichtlichkeit versetzt zur Ebene der Widerstandsstreifen 54 skizziert sind, allerdings in dieser Ebene allokiert sind. Magnetfeldvektoren *B*_{y} und *B_{z}*, die senkrecht zu diesen Ebenen 40a, 40b ausgerichtet sind, d.h. diese Ebenen in Normalenrichtung durchdringen, haben zumindest bis zu einer maximalen Magnetfeldstärke keinen nennenswerten Einfluss auf eine Widerstandsänderung der Widerstandsstreifen 54. Hierbei beeinflussen Magnetfeldkomponenten, die durch die Ebene 40a durchdringen, den Sensorwert nicht. Magnetfeldkomponenten, die durch die Ebene 40b treten, können die Magnetfeldempfindlichkeit der Widerstandsstreifen 54 verändern bzw. herabsetzen oder stören und sind somit zu vermeiden. Anders verhält es sich mit einer Magnetfeldvektorkomponente *B*ₓ, die senkrecht zur magnetfeldsensitiven Ausrichtungsebene 42 in einer Empfindlichkeitsrichtung 70 steht, und deren Größe maßgeblich eine Widerstandsveränderung der Widerstandsstreifen 54 bewirkt. Durch eine dreidimensionale Ausrichtung der Ebene, die die Sensorstruktur 11 aufnimmt, gegenüber dem Stromleiter 12 wird folgendes erreicht: Die strommessparasitären Magnetfelder, die von dem Verbindungssteg 5 und stromzuführenden Anschlussleitungen 3 sowie Versorgungsleitungen des Sensorelements 10 verursacht werden, durchdringen am Ort der Sensorstrukturen die magnetfeldneutralen Ausrichtungsebenen 40a, 40b, insbesondere die Ausrichtungsebene 40a senkrecht. Die Ausrichtungsebene 40a ist deckungsgleich zur Anordnungsebene der Sensorstrukturen 11. Somit kann der störende Einfluss parasitärer Magnetfelder wirksam unterdrückt werden und der Sensorwert wird vornehmlich bis ausschließlich von den Magnetfeldern der strommessaktiven Leiterabschnitte 30 beeinflusst. Bei der Ausrichtung ist weiter angestrebt, dass die von dem strommessaktiven Leiterabschnitt 30, insbesondere von dem Schenkel 4 des U-förmigen Stromleiterelements 2 erzeugten Magnetfelder die magnetfeldsensitive Ausrichtungsebene 42 bevorzugt rechtwinklig durchsetzen.

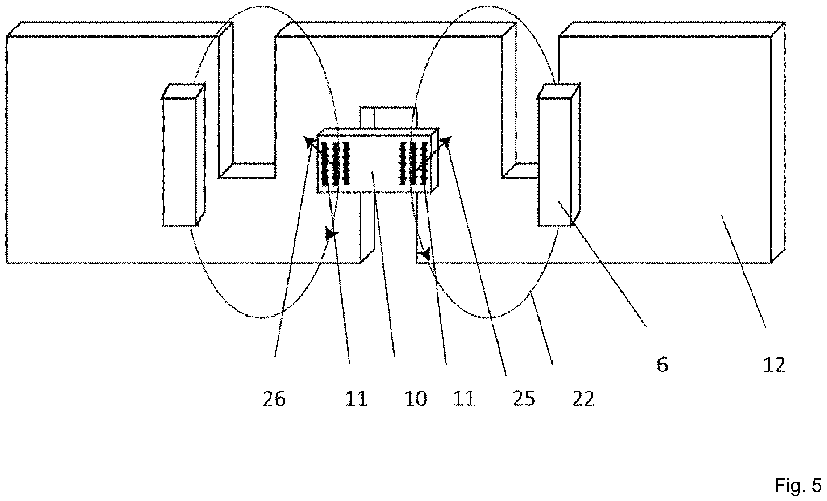

In Figur 5 ist gezeigt, welche resultierenden Magnetfelder 25, 26 am Ort der Sensorstrukturen 11 entstehen, wenn sich die verschiedenen in Figur 3 dargestellten Magnetfelder am Ort des Sensors überlagern. Es ist gut erkennbar, dass die Magnetfelder 25 und 26 Komponenten aufweisen, die auch das Stütz-Magnetfeld, erzeugt durch die Permanentmagneten 6, am Ort der Sensorstrukturen 11 schwächen. Mit zunehmendem Stromfluss kann dies zu Fehlmessungen und gegebenenfalls zu Ummagnetisierungsvorgängen am Ort der Sensorstrukturen 11 führen.

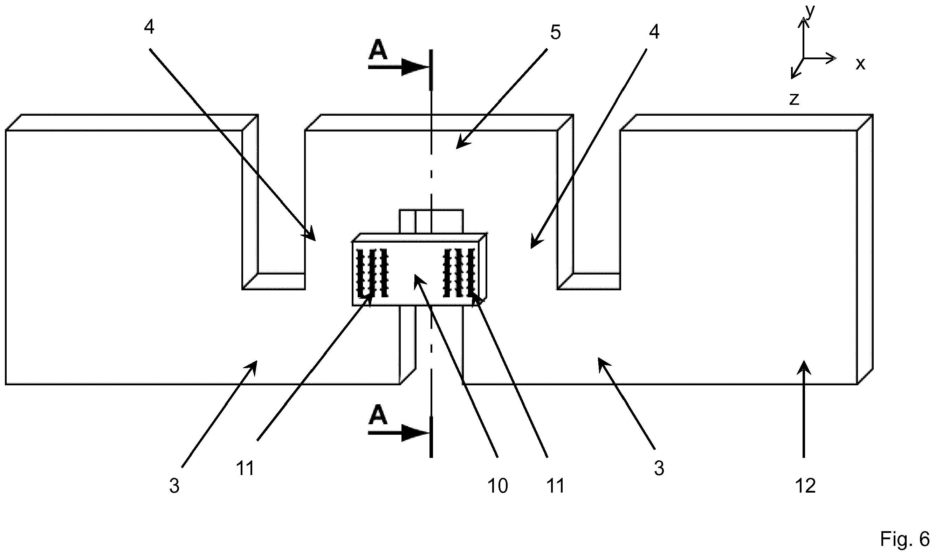

In Figur 6 ist eine Anordnung gezeigt, welche aus einem geraden Stromleiter 12 besteht, welcher eine Teilstruktur bestehend aus Anschlussleitungen 3, den Schenkeln 4 und einem Verbindungssteg 5 aufweist. Über dem Stromleiter 12 ist ein Sensorelement 10 mit den Sensorstrukturen 11 angeordnet.

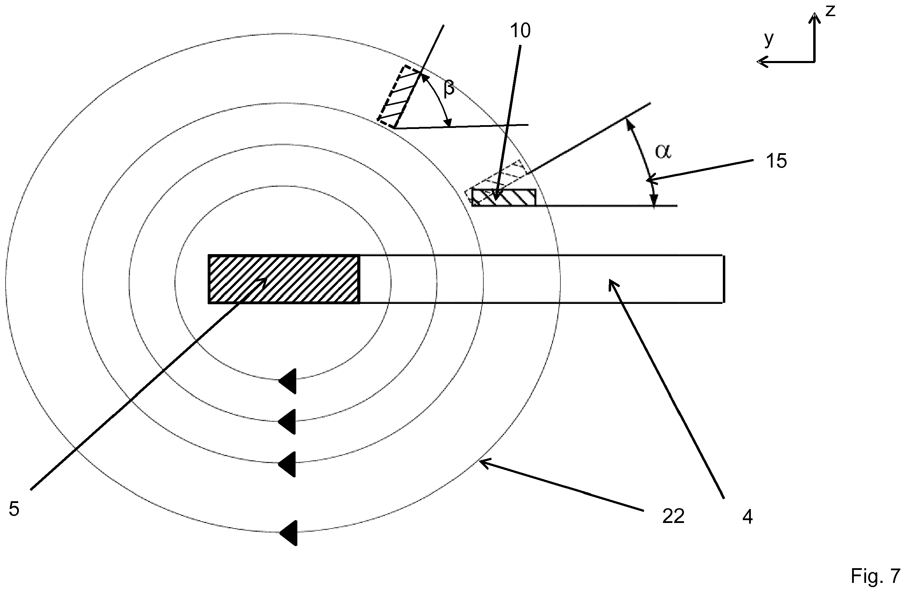

Figur 7 zeigt in einem nicht maßstabsgerechten Schnittbild von Fig. 6 entlang der Linie A-A parasitäre Magnetfeldlinien 22, die durch einen Stromfluss im Verbindungssteg 5 erzeugt werden. Das Sensorelement 10 befindet sich oberhalb der Schenkel 4 des U-förmigen Leiterelementes. Wird das Sensorelement 10, z.B. aufgrund von Anforderungen zur Isolationsfestigkeit im Abstand zum Stromleiter 12 und parallel zur Ebene des Stromleiters 12 montiert, so durchdringen die Feldlinien 22 das Sensorelement 10 nicht senkrecht. Es existieren also Magnetfeldkomponenten in der Ebene des Sensorelementes 10, welche das Messsignal bei einem in der Ebene empfindlichen Sensorelement 10 verfälschen. Durch eine erfindungsgemäße gekippte Lage des Sensorelementes 10 um einen Winkel α 15 bezogen auf die Ebene des Stromleiters 12, kann erreicht werden, dass die Magnetfeldlinien 22 senkrecht auf das Sensorelement 10 auftreffen. Weist das Sensorelement 10 Sensorstrukturen auf, die unempfindlich gegenüber senkrecht auftreffenden Magnetfeldern sind, so wirken sich durch Ströme im Verbindungssteg 5 und in den Anschlussleitungen 3 verursachte Magnetfelder nicht mehr störend aus. Verändert man die Lage des Sensorelementes 10 z.B. entlang der geschlossenen Magnetfeldlinien, so geht erfindungsgemäß mit zunehmendem Kippwinkel auch eine Vergrößerung des Abstandes zu den Schenkeln 4 des U-förmigen Leiterelements 2 einher. In Fig. 7 ist zur Erläuterung eine weitere Position mit dem zugehörigen optimalen Kippwinkel β, aber mit vergrößertem Abstand zum Stromleiter 12 gezeigt. Eine weitere Verdrehung des Sensorelementes 10 entlang der Magnetfeldlinien ist möglich, wobei sich die Empfindlichkeit der Anordnung 1 aufgrund der Veränderung des Abstandes entsprechend mit verändert. Es ist aus Fig. 7 leicht erkennbar, dass eine zur Ebene des Stromleiters gespiegelte Anordnung, d.h. Sensorelement 10 unterhalb des Stromleiters 10 und mit negativem Kippwinkel sich gleichermaßen vorteilhaft darstellt.

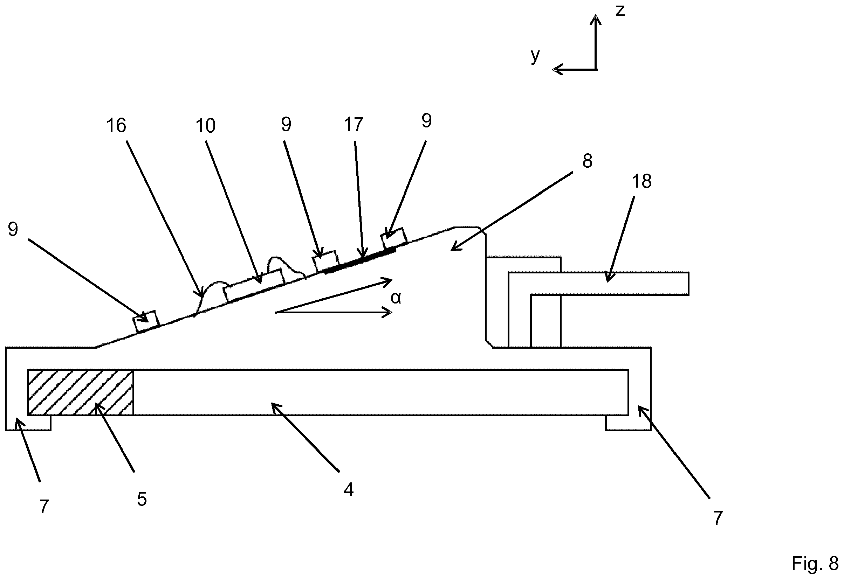

In Figur 8 ist schematisch ein Befestigungsmittel 8 gezeigt, welches das Sensorelement 10 aufnimmt und in einer gekippten Lage in Bezug auf das in den Figuren 5 und 6 dargestellte Leiterelement 4 fixiert. Auf dem Befestigungsmittel 8 können zusätzliche Bauelemente 9 montiert sein. Für die elektrische Verbindung der Komponenten sind beispielhaft Bonddrähte 16 und Leiterbahnen 17 gezeigt. Das Befestigungsmittel 8 ist so gestaltet, dass es auf die vorgegebene Struktur des Stromleiters 12 einrastet. Dazu sind beispielweise Rasthaken 7 vorgesehen, welche nach der Montage des Befestigungsmittels 8 den Stromleiter 12 teilweise umfassen. Vorzugsweise kann das Befestigungsmittel 8 aus einem Kunststoff bestehen. Zusätzliche Steckverbinder 18 können mit dem Befestigungselement 8 verbunden sein und die (nicht weiter gezeigte) elektrische Kontaktierung der Bauelemente 9 und des Sensorelementes 10 ermöglichen. Alternativ können die Bauelemente 9 und das Sensorelement 10 auch zunächst auf einer Leiterplatte montiert sein, die dann auf das Befestigungsmittel 8 montiert wird. Der dargestellte Kippwinkel α des Befestigungselements 8 kann weiterhin optimiert werden. Es ist alternativ oder zusätzlich denkbar, im Befestigungsmittel 8 oder in einer darauf montierten Leiterplatte zumindest teilweise magnetisch anisotropes Material vorzusehen, oder in unmittelbarer Umgebung des Sensorelements 10 ein magnetisch anisotropes Material anzuordnen, das einen Permeabilitätstensor aufweist, der den Verlauf des parasitären Magnetfelds in Richtung der Normalen zu einer magnetfeldneutralen Ausrichtungsebene 40 beeinflusst. Somit können beispielsweise mechanische Zwangsvorgaben entsprochen und die Empfindlichkeit der Sensoranordnung weiterhin verbessert werden, da die parasitären Magnetfelder entlang eines durch das Permitivitäts-Tensormaterial definierten Feldlinienverlaufs vorteilhaft von einer Empfindlichkeitsrichtung weggeführt werden.

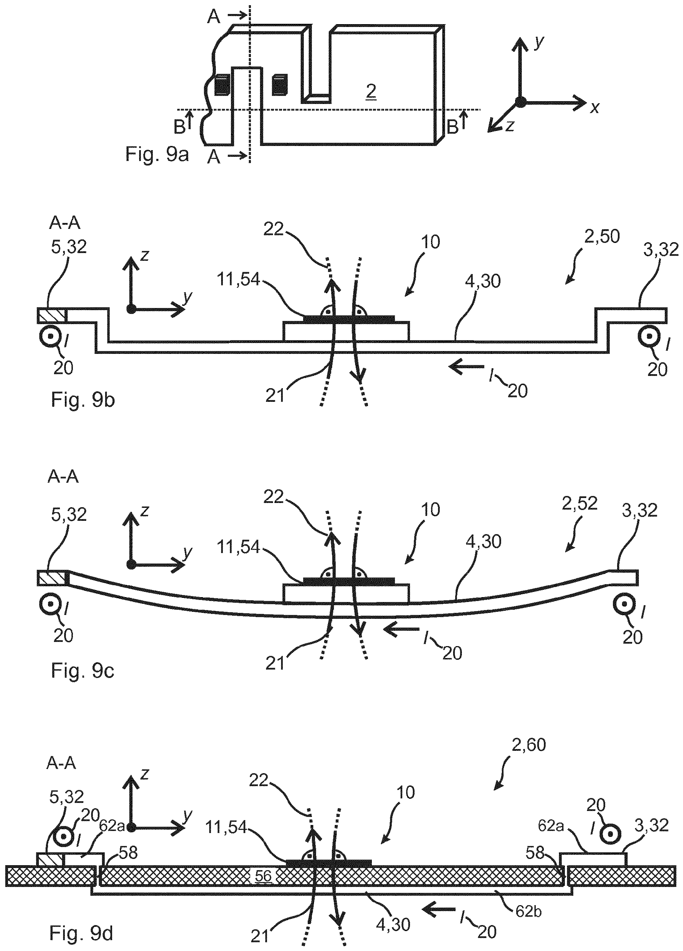

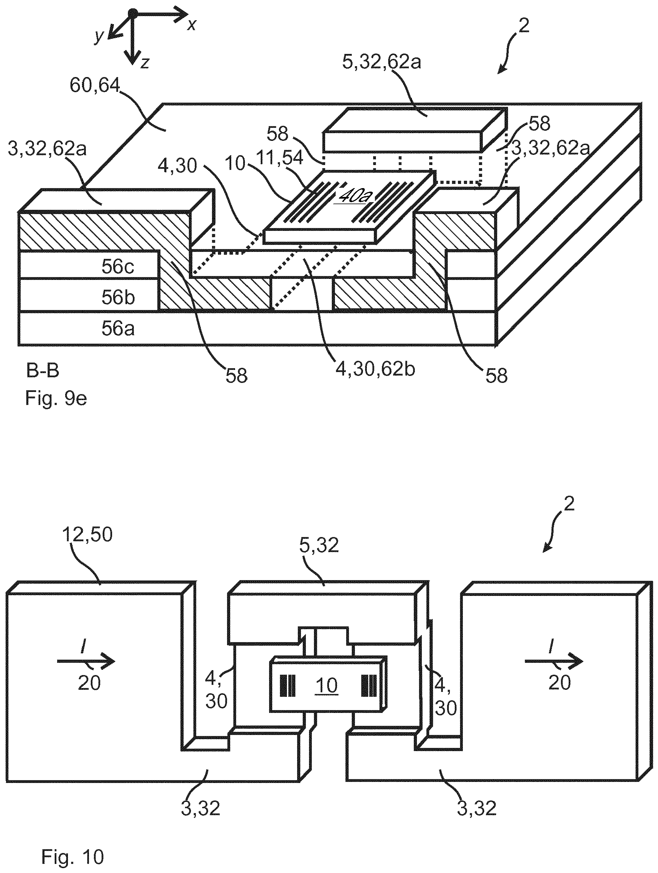

Die Figur 9 stellt schematische, nicht maßstabsgerechte Schnittdarstellungen mehrerer Sensoranordnungs-Ausführungsformen mit verschiedenen dreidimensionalen Anordnungen von strommessaktiven zu strommessparasitären Leiterabschnitten dar. Hierzu zeigt Fig. 9a schematisch eine Schnittlinie A-A durch ein U-förmiges Stromleiterelement 2 eines Stromleiters 10, wie es bereits in der Figur 6 dargestellt ist, und der die Schnittansichten der Figs. 9b bis 9d definiert. Eine weitere Schnittlinie B-B definiert die Ansichtsebene der Fig. 9e.

Die Figur 9b zeigt eine erste Ausführungsform des U-förmigen Stromleiterelements 2 als Stanzbiegeteil 50, bei dem ein Schenkel 4 als strommessaktiver Leiterabschnitt 30 in einer unteren z-Ebene in y-Richtung ausgerichtet ist und der Verbindungssteg 5 und die Anschlussleitungen 3 als strommessparasitäre Leiterabschnitte 32 in x-Richtung auf einer oberen z-Ebene ausgerichtet sind. Schematisch ist die Stromflussrichtung 20 eines zu messenden Stroms I dargestellt. Ein Sensorelement 10 ist im Mittelbereich des Schenkels 4 angeordnet und umfasst Sensorstrukturen 11, die beispielsweise als Widerstandsstreifen 54 ausgebildet sind, die ebenfalls in y-Richtung ausgerichtet sind, und deren magnetfeldsensitive Ausrichtungsebene in der y/z-Ebene liegt und von in x-Richtung orientierten Magnetfeldkomponenten des in y-Richtung fließenden Stroms I durch den Schenkel 4, 30 durchsetzt wird. Gestrichelt sind Magnetvektorkomponenten des Verbindungsstegs 5 und der Anschlussleitungen 3 als strommessparasitäre Leiterabschnitte 32 dargestellt. Aufgrund der Anordnung des strommessaktiven Leiterabschnitts 30 auf einer unteren z-Ebene und der strommessparasitären Leiterabschnitte 32 auf einer oberen z-Ebene, wobei auf der oberen z-Ebene ebenfalls die in der x/y-Ebene liegende magnetfeldneutrale Ausrichtungsebene 40a (vgl. Fig. 4) liegt, durchdringen die parasitären Magnetfeldkomponenten die Ebene 40a in einem rechten Winkel und haben keinen Einfluss auf eine Sensorwertänderung des Sensorelements 10. Der z-Höhenversatz zwischen strommessaktivem Leiterabschnitt 30 und strommessparasitären Leiterabschnitten 32 ist derart gewählt, dass der Schwerpunkt der Stromdichtenverteilung des zu messenden Stroms 20 durch die strommessparasitären Leiterabschnitte 32, der einem Linienstrom entspricht, auf derselben z-Höhenebene wie die magnetfeldneutrale Ausrichtungsebene 40a liegt, so dass ein rechtwinkliger Durchtritt der parasitären Magnetfeldkomponenten durch die Ebene 40a gewährleistet ist.

In der Fig. 9c ist eine ähnliche Konfiguration wie in Fig. 9b als Schnitt A-A dargestellt, allerdings ist das U-förmige Stromleiterelement 2 als graduell gebogener Leiterabschnitt 52 mit großen Krümmungsradius und nicht als Stanzbiegeteil 50 mit kleinen Biegeradien ausgeformt. Die Ausbildung des strommessaktiven Schenkels 4, 30 als gebogener Leiterabschnitt 52 hat den Vorteil, dass Herstellungstoleranzen herausgemittelt werden, bzw. ein geringfügig anderer Krümmungsradius nur geringen Einfluss auf den oben angesprochenen rechtwinkligen Durchtrittswinkel durch die magnetfeldneutrale Ausrichtungsebene 40a hat. Somit können die Stromleiterelemente mit höherer Fehlertoleranz gefertigt bzw. nachträglich gerichtet werden.

In der Fig. 9d ist eine vergleichbare Konfiguration wie in Fig. 9b als Schnitt A-A dargestellt, allerdings handelt es sich bei dem U-förmigen Stromleiterelement 2 nicht um ein Stanzbiegeteil 50, sondern um eine PCB-Anordnung 60 (Printed Circuit Board) oder um eine Chipsubstratanordnung, bei dem auf einer unteren Layerebene bzw. unterhalb einer Substratschicht 56 der strommessaktive Schenkelleiterabschnitt 4, 30 als ein unterer Metallisierungslayer 62b angeordnet ist, und die strommessparasitären Verbindungssteg- und Anschlussleiterabschnitte 3, 5, 32 auf einer oberen Layerebene bzw. auf der Substratschicht 56 als ein oberer Metallisierungslayer 62a angeordnet sind. Die Leiterabschnitte 3, 4 und 5 sind durch Vias 58 miteinander verbunden. Auf der Substratoberfläche 56 sind die Sensorstrukturen 11 des Sensorelements aufgebraucht, so dass die parasitären Magnetfeldkomponenten senkrecht zur Substratoberfläche die Sensorstrukturen 11 durchdringen.

Die Fig. 9e zeigt ein weiteres dreidimensionales und in Z-Richtung betrachtet U-förmiges Stromleiterelement 2 innerhalb einer PCB-Anordnung 60. Die PCB-Anordnung 60 ist ein Mehrlagen-PCB 64 mit mehreren Layern 56a bis 56c. Auf der obersten Layerebene 56c ist ein Metallisierungslayer 62a aufgebracht, der den Verbindungssteg 5 und Anschlussleitungen 3des U-förmigen Leiterelements 2 ausbilden und strommessparasitäre Leiterabschnitte 32 darstellen. In einer z-höhenversetzten Layerebene 56b sind strommessaktive Leiterabschnitte 30 als Schenkel 4 in einem Metallisierungslayer 62b ausgebildet. Die Metallisierungslayer 62a, 62b sind mittels Vias 58, d.h. Durchkontaktierungen durch die PCB-Substratschicht 56c elektrisch miteinander verbunden. Ein Sensorelement 10, dass Sensorstrukturen 11 in Form vom magnetfeldsensitiven Widerstandsstreifen 54 auf einer magnetfeldneutralen Ausrichtungsebene 40a umfasst, ist auf der Layerebene 56c im Bereich der Schenkel 4 angeordnet. Die magnetfeldneutrale Ausrichtungsebene 40a ist in einer Höhe z angeordnet, die der z-Höhe und Ausrichtung eines konzentrierten Linienstroms / 20 entspricht, der verteilt durch die strommessparasitären Leiterabschnitte 32 fließt. Somit durchdringen parasitäre Magnetfelder, die, wie in Fig. 7 dargestellt, in der Regel konzentrische Kreise 22 um die strommessparasitären Leiterabschnitte 32 bilden, die magnetfeldneutrale Ausrichtungsebene 40a in Normalenrichtung zur Ebene 40a. Die Sensorstruktur 11 weist eine Empfindlichkeitsrichtung 70 auf, die in x-Richtung weist, somit innerhalb der Ausrichtungsebene 40a liegt und rechtwinklig zur Ausrichtung der parasitären Magnetfelder 22 liegt. Diese Sensor-Anordnung beruht wie die in den Figs. 9b bis 9d gezeigten Anordnungen auf einer räumlich versetzten Anordnung des Sensorelements 10, so dass parasitäre Magnetfelder nicht in Empfindlichkeitsrichtung, insbesondere rechtwinklig zur Empfindlichkeitsrichtung das Sensorelement durchdringen.

In der Fig. 10 ist entsprechend zur Schnittbild-Ausführungsform der Fig. 9b ein U-förmiges Stromleiterelement 2 als Stanzbiegeteil 50 dargestellt, bei dem die strommessaktiven Schenkel 4, 30 in einer z-Richtung gegenüber den strommessparasitären Schenkel- und Anschlussleiterabschnitten 3, 5, 32 zurückversetzt sind, so dass parasitäre Magnetfeldkomponenten im Wesentlichen rechtwinklig eine magnetfeldneutrale Ausrichtungsebene 40a, - siehe Fig. 4, auf dem Sensorstrukturen 11 des Sensorelements 10 angeordnet sind, durchdringen. Durch die in z-Richtung versetzte Anordnung von Schenkel 4 gegenüber den Anschlussleitungen 3 und dem Verbindungssteg 5 wird erreicht, dass parasitäre Magnetfeldkomponenten lediglich durch die magnetfeldneutrale Ausrichtungsebene 40a treten, während die zu erfassenden strommessaktiven Magnetfeldkomponenten durch die magnetfeldsensitive Ausrichtungsebene 42 des Sensorelements 10 treten.

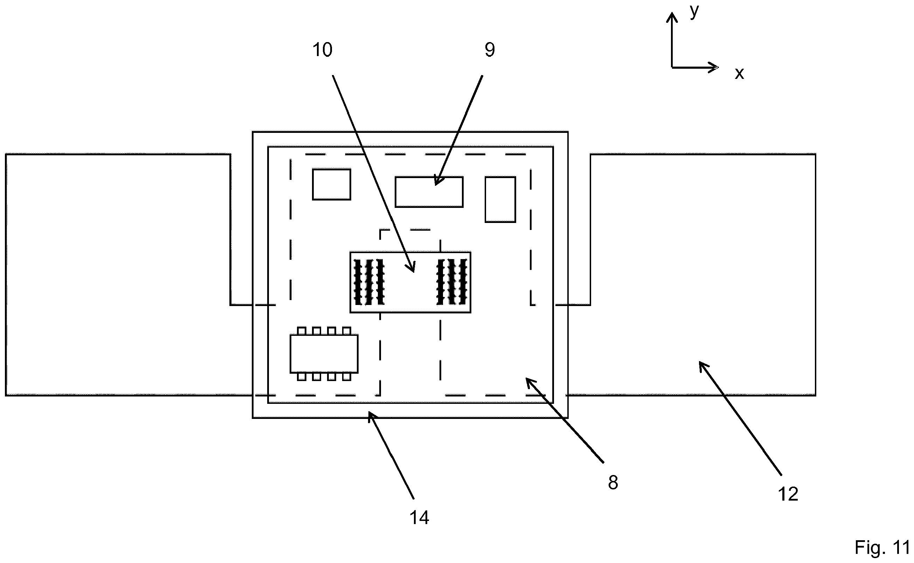

In Figur 11 ist ein weiteres vorteilhaftes Ausführungsbeispiel mit einem geraden Stromleiter 12 in Draufsicht gezeigt, bei dem das Befestigungsmittel 8 mit den zugehörigen Komponenten Sensorelement 10, Bauelemente 9 dargestellt ist, welches dann mit einer Umhüllung 14 gegen mechanische Einflüsse von außen geschützt wird.

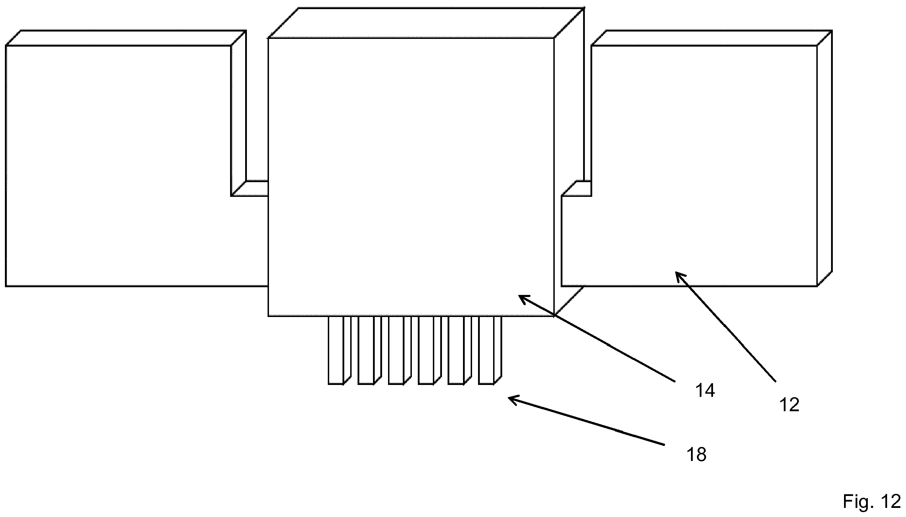

In Figur 12 ist ein weiteres vorteilhaftes Ausführungsbeispiel gezeigt, bei dem das (nicht mehr sichtbare) Befestigungsmittel 8 durch eine Umhüllung 14 geschützt wird, wobei die Umhüllung 14 gleichzeitig eine Einheit mit dem geraden Stromleiter 12 herstellt. Die Kontaktierung des mindestens einen Sensorelementes 10 und von eventuell vorhandenen Bauelementen 9 erfolgt über die gezeigten Kontakte eines Steckverbinders 18, der ansonsten von der Umhüllung 14 umfasst wird.

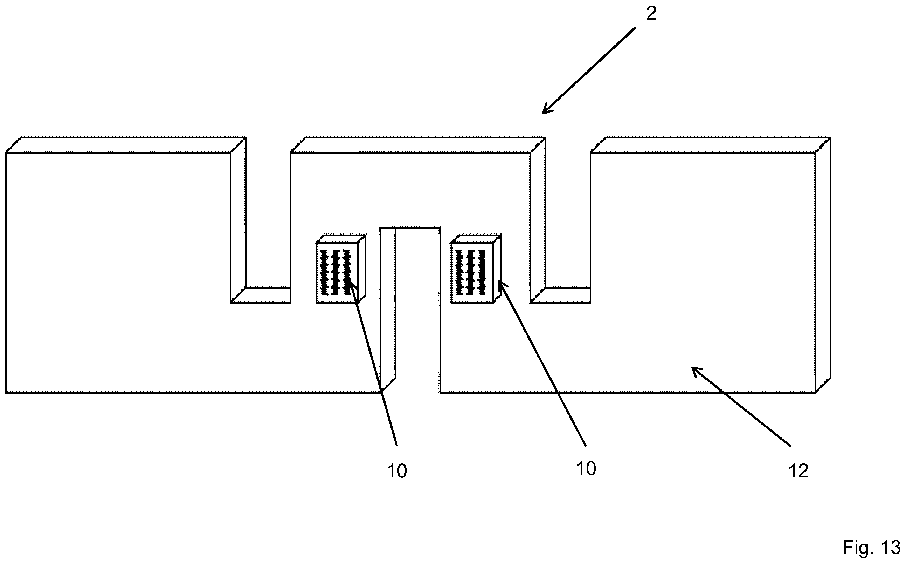

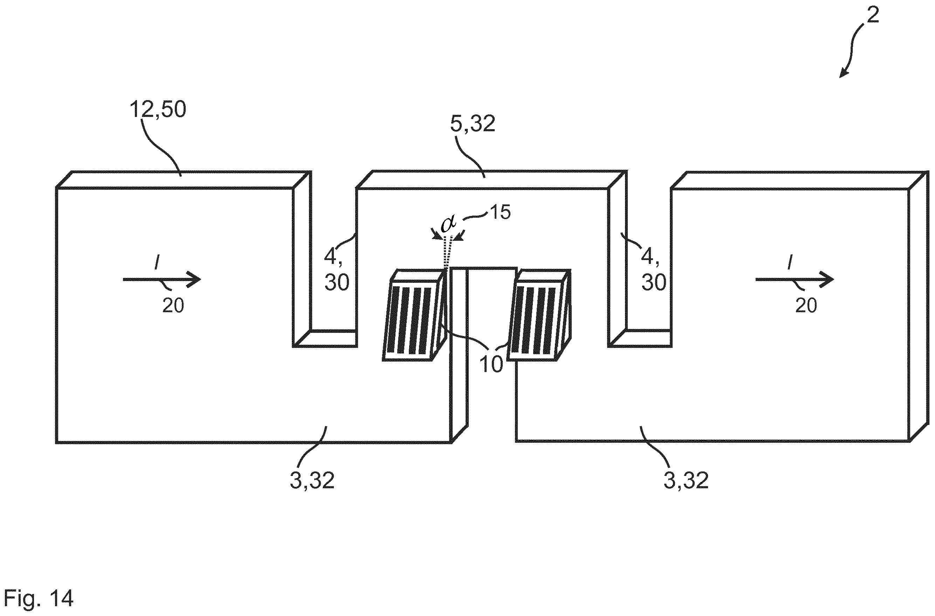

Anstelle eines Sensorelemente 10 können, wie in Figur 13 gezeigt, auch mehrere Sensorelemente 10 im Bereich des U-förmigen Leiterelementes 2 angeordnet sein, die dann erfindungsgemäß gekippt zu dem den Sensorelementen 10 zugeordneten Leiterelement 17 angeordnet werden. Eine derartige Ausführungsform ist ebenfalls in Fig. 14 dargestellt, wobei der Kippwinkel α 15 entsprechend der in Fig. 7 dargestellten Konfiguration gewählt ist. Zur definierten Einstellung des Kippwinkels 15 kann ein Befestigungsmittel 8 ausgebildet sein, dass auf dem Leiter 12 bzw. auf dem Schenkel 4 derart befestigt wird, um die gewünschte Winkelausrichtung bereitzustellen.

Eine optimierte Positionierung des Sensorelements 10 relativ zu den Leiterelementen 3, 4 und 5 kann zum einen rein durch Erfahrungswerte oder empirischen Untersuchungen, zum anderen mittels einer numerischen Feldsimulation des statischen Magnetfeldes oder einer transienten Feldverteilung bei einer vorgegebenen Leiterstruktur 12 bestimmt werden. Hierzu eigenen sich numerische Simulationsverfahren, insbesondere auf Basis finiter Elemente oder finiter Differenzen, die eine Magnetfeldverteilung bei vorgegebenem Stromfluss durch eine vorgegebene Stromleiterkonfiguration 12 bestimmen können. Anhand der parasitären Magnetfeldkomponenten, die beispielsweise durch eine Stromeinprägung lediglich in den strommessparasitären Leiterabschnitten 32 einzeln betrachtet werden können, kann somit eine geeignete Ausrichtung des Sensorelements ermittelt werden, die in einem modifizierten Kippwinkel, in einer höhendefinierten Ausrichtung der Leiterelemente zueinander, einer parasitären Magnetfeldkompensation oder einer Kombination hieraus beruhen kann.

## Patentansprüche

1. Anordnung zur magnetfeldbasierten Messung von elektrischen Strömen mittels mindestens einem magnetfeldempfindlichen Sensorelement (10) in einem abgewinkelten, insbesondere U-förmigen Leiterelement (2), das zumindest einen strommessaktiven Leiterabschnitt (4, 30) und zumindest einen strommessparasitären Leiterabschnitt (5, 32) umfasst, **dadurch gekennzeichnet, dass** das Sensorelement (10) zumindest eine Empfindlichkeitsrichtung (70) aufweist, in der Magnetfeldkomponenten eine hohe Sensorwertveränderung bewirken, wobei das Sensorelement (10) gegenüber dem strommessparasitären Leiterabschnitt (4,32) verkippt und/oder gegenüber dem strommessparasitären Leiterabschnitt (5,32) höhenversetzt ist, so dass das Magnetfeld des strommessaktiven Leiterabschnitts (4, 20) im Wesentlichen in Empfindlichkeitsrichtung (70) ausgerichtet ist und das Magnetfeld des strommessparasitären Leiterabschnitts (5, 32) im Wesentlichen nicht in Empfindlichkeitsrichtung (70), insbesondere rechtwinklig zur Empfindlichkeitsrichtung (70) ausgerichtet ist.

2. Anordnung nach Anspruch 1 **dadurch gekennzeichnet, dass** das mindestens eine Sensorelement (10) gekippt zu dem Sensorelement (10) zugeordneten Leiterelement (2) angeordnet ist.

3. Anordnung nach Anspruch 2 **dadurch gekennzeichnet, dass** der Kippwinkel (15) so gewählt wird, dass die in der Empfindlichkeitsrichtung (70) des Sensorelementes (10) liegenden parasitären Komponenten des Magnetfeldes, welche durch Ströme im Verbindungssteg (5) zwischen den beiden Schenkeln (4) des U-förmigen Leiterelements (2) erzeugt werden, am Ort des Sensorelementes (10) minimiert sind, oder dass der Kippwinkel (15) so gewählt wird, dass die in der Empfindlichkeitsrichtung (70) des Sensorelementes (10) liegenden parasitären Komponenten des resultierenden Magnetfeldes, welches durch Überlagerung des durch Ströme im Verbindungssteg (5) zwischen den beiden Schenkeln (4) des U-förmigen Leiterelements (2) erzeugten Magnetfeldes und des durch Ströme durch die Anschlussleitungen (3) zum U-förmigen Leiterelements (2) erzeugten Magnetfeldes am Ort des Sensorelementes (10) minimiert sind.

4. Anordnung nach einem der vorangegangenen Ansprüche, **dadurch gekennzeichnet, dass** das Sensorelement (10) ein Gradientensensor oder ein Absolutfeld messender Sensor ist, wobei das Sensorelemente (10) vorzugsweise ein magnetoresistiver Sensor ist.

5. Anordnung nach einem der vorangegangenen Ansprüche, **dadurch gekennzeichnet, dass** das abgewinkelte, bevorzugt U-förmige Leiterelement (2) durch Schlitze (13) in einem flachen geraden Leiterstück (12) ausgeformt ist, wobei insbesondere die beiden Schenkel des U förmigen Leiterelements parallel zueinander ausgerichtet sind.

6. Anordnung nach einem der vorangegangenen Ansprüche, **dadurch gekennzeichnet, dass** zumindest ein Befestigungsmittel (8) vorgesehen ist, dass das mindestens eine Sensorelement (10) aufnimmt und in die gekippte Lage in Bezug auf das zugeordnete U-förmige Leiterelement (2) fixiert.

7. Anordnung nach Anspruch 6, **dadurch gekennzeichnet, dass** das Befestigungsmittel (8) in oder an einem geraden Leiterstück (12) oder einem U-förmigen Leiterelement (2) einrastet.

8. Anordnung nach Anspruch 6, **dadurch gekennzeichnet, dass** das Befestigungsmittel (8) zumindest eine elektrische Leiterbahn (17) aufweist, welche das mindestens eine Sensorelement (10) elektrisch kontaktiert.

9. Anordnung nach Anspruch 6, **dadurch gekennzeichnet, dass** das Befestigungsmittel (8) in MID-Technik (Molded Interconected Devices) ausgeführt ist.

10. Anordnung nach Anspruch 6, **dadurch gekennzeichnet, dass** dem mindestens einen Sensorelement (10) zugeordnete Elektronikkomponenten (9) auf dem Befestigungsmittel (8) angeordnet sind.

11. Anordnung nach Anspruch 6, **dadurch gekennzeichnet, dass** eine schützende Umhüllung (14) mindestens um das Befestigungsmittel (8) mit dem mindestens einen Sensorelement (10) vorgesehen ist, wobei die Umhüllung (14) vorzugsweise Teile des U-förmigen Leiterelementes (2) umfasst.

12. Anordnung nach einem der vorangegangenen Ansprüche, **dadurch gekennzeichnet, dass** die dreidimensionale räumliche Anordnung von Sensorelement (10) und strommessparasitärem Leiterabschnitt (4,30) derart zueinander steht, so dass die Empfindlichkeitsrichtung (70) am Ort des Sensorelements (10) rechtwinklig zu einer Tangente einer geschlossenen Magnetfeldlinie des durch die Stromverteilung des strommessparasitären Leiterabschnitts (4,30) erzeugten parasitären Magnetfeldes ausgerichtet ist.

13. Anordnung nach Anspruch 12, **dadurch gekennzeichnet, dass** das Leiterelement (2) ein metallisches Stanzbiegeteil (50) ist, wobei der Schwerpunkt der Stromdichteverteilung durch den strommessparasitären Leiterabschnitt (5, 32) und eine magnetfeldneutrale Ausrichtungsebene (40), dessen Normale rechtwinklig zur Empfindlichkeitsrichtung (70) ist, am Ort des Sensorelements (10) im Wesentlichen in der gleichen Höhenebene z liegen.

14. Anordnung nach Anspruch 12, **dadurch gekennzeichnet, dass** das Sensorelement (10) auf einem gebogenen strommessaktiven Leiterabschnitt (4, 30, 52) angeordnet ist, wodurch der Schwerpunkt der Stromdichteverteilung durch den strommessparasitären Leiterabschnitt (5, 32) und eine magnetfeldneutrale Ausrichtungsebene (40), dessen Normale rechtwinklig zur Empfindlichkeitsrichtung (70) ist, am Ort des Sensorelements (10) im Wesentlichen in der gleichen Höhenebene z liegen.

15. Anordnung nach einem der Ansprüche 12 bis 14, **dadurch gekennzeichnet, dass** strommessaktive und strommessparasitäre Leiterabschnitte (4, 5, 30, 32, 52) auf oder in einer PCB-Anordnung (60), insbesondere in einem Mehrlagen-PCB (Printed Circuit Board) (64) auf höhenversetzten Layern (56) angeordnet sind.

## Claims

1. Arrangement for magnetic field-based measurement of electric currents by means of at least one magnetic-field-sensitive sensor element (10) in an angled, in particular U-shaped conductor element (2), which comprises at least one current-measuring-active conductor section (4, 30) and at least one current-measuring-parasitic conductor section (5, 32), **characterized in that** the sensor element (10) has at least one sensitivity direction (70) in which magnetic field components effect a high sensor value change, where the sensor element (10) is tilted relative to the current-measuring-parasitic conductor section (5, 32) and/or height-offset relative to the current-measuring-parasitic conductor section (5, 32), such that the magnetic field of the current-measuring-active conductor section (4, 30) is aligned substantially in the sensitivity direction (70) and the magnetic field of the current-measuring-parasitic conductor section (5, 32) is aligned substantially not in the sensitivity direction (70), in particular at right angles to the sensitivity direction (70).

2. Arrangement according to claim 1, **characterized in that** the at least one sensor element (10) is arranged tilted relative to the conductor element (2) associated with the sensor element (10).

3. Arrangement according to claim 2, **characterized in that** the tilt angle (15) is selected such that the parasitic components of the magnetic field lying in the sensitivity direction (70) of the sensor element (10), which are generated by currents in the connecting bridge (5) between the two legs (4) of the U-shaped conductor element (2), are minimized at the location of the sensor element (10), or **in that** the tilt angle (15) is selected such that the parasitic components of the resultant magnetic field lying in the sensitivity direction (70) of the sensor element (10) are minimized at the location of the sensor element (10), said magnetic field being formed by superimposition of the magnetic field generated by currents in the connecting bridge (5) between the two legs (4) of the U-shaped conductor element (2) and of the magnetic field generated by currents through the connecting lines (3) to the U-shaped conductor element (2).

4. Arrangement according to one of the preceding claims, **characterized in that** the sensor element (10) is a gradient sensor or an absolute field measuring sensor, where the sensor element (10) is preferably a magnetoresistive sensor.

5. Arrangement according to one of the preceding claims, **characterized in that** the angled and preferably U-shaped conductor element (2) is formed by slots (13) in a flat and straight conductor portion (12), where in particular the two legs of the U-shaped conductor element are aligned parallel to one another.

6. Arrangement according to one of the preceding claims, **characterized in that** at least one fastening means (8) is provided which receives the at least one sensor element (10) and fixes it in the tilted position relative to the associated U-shaped conductor element (2).

7. Arrangement according to claim 6, **characterized in that** the fastening means (8) engages in or on a straight conductor portion (12) or a U-shaped conductor element (2).

8. Arrangement according to claim 6, **characterized in that** the fastening means (8) has at least one electrical conductor path (17) which electrically contacts the at least one sensor element (10).

9. Arrangement according to claim 6, **characterized in that** the fastening means (8) is designed with MID (Molded Interconnect Device) technology.

10. Arrangement according to claim 6, **characterized in that** electronic components (9) associated with the at least one sensor element (10) are arranged on the fastening means (8).

11. Arrangement according to claim 6, **characterized in that** a protective enclosure (14) is provided at least around the fastening means (8) with the at least one sensor element (10), where the enclosure (14) preferably comprises parts of the U-shaped conductor element (2).

12. Arrangement according to one of the preceding claims, **characterized in that** the three-dimensional spatial arrangement of the sensor element (10) and the current-measuring-parasitic conductor section (5, 32) relative to one another is such that the sensitivity direction (70) at the location of the sensor element (10) is aligned at right angles to a tangent of a closed magnetic field line of the parasitic magnetic field generated by the current distribution of the current-measuring-parasitic conductor section (5, 32).

13. Arrangement according to claim 12, **characterized in that** the conductor element (2) is a metallic stamped and bent part (50), where the centre of mass of the current density distribution through to the current-measuring-parasitic conductor section (5, 32) and a magnetic-field-neutral alignment plane (40) whose normal is at right angles to the sensitivity direction (70) are substantially in the same height plane z at the location of the sensor element (10).

14. Arrangement according to claim 12, **characterized in that** the sensor element (10) is arranged on a curved current-measuring-active conductor section (4, 30, 52), whereby the centre of mass of the current density distribution through to the current-measuring-parasitic conductor section (5, 32) and a magnetic-field-neutral alignment plane (40) whose normal is at right angles to the sensitivity direction (70) are substantially in the same height plane z at the location of the sensor element (10).

15. Arrangement according to one of claims 12 to 14, **characterized in that** current-measuring-active and current-measuring-parasitic conductor sections (4, 5, 30, 32, 52) are arranged on or in a PCB arrangement (60), in particular in a multilayer PCB (printed circuit board) (64) on height-offset layers (56).

## Revendications

1. Dispositif destiné à la mesure à base de champs magnétiques de courants électriques au moyen d'au moins un élément capteur sensible aux champs magnétiques (10) dans un élément conducteur (2) coudé, notamment en forme de U qui comprend au moins une partie de conducteur active lors de la mesure de courant (4, 30) et au moins une partie de conducteur parasite lors de la mesure de courant (5, 32), **caractérisé en ce que** l'élément capteur (10) présente au moins une direction de sensibilité (70) dans laquelle les composantes du champ magnétique provoquent un fort changement de la valeur du capteur, sachant que l'élément capteur (10) est incliné par rapport à la partie de conducteur parasite lors de la mesure de courant (5, 32) et/ou est décalé en hauteur par rapport à la partie de conducteur parasite lors de la mesure de courant (5, 32) de telle sorte que le champ magnétique de la partie de conducteur active lors de la mesure de courant (4, 30) est dirigé essentiellement dans la direction de sensibilité (70) et que le champ magnétique de la partie de conducteur parasite lors de la mesure de courant (5, 32) est essentiellement non dirigé dans la direction de sensibilité (70) et est dirigé notamment à angle droit de la direction de sensibilité (70).

2. Dispositif selon la revendication 1, **caractérisé en ce que** ledit au moins un élément capteur (10) est incliné vers l'élément conducteur (2) associé à l'élément capteur (10).

3. Dispositif selon la revendication 2, **caractérisé en ce que** l'angle d'inclinaison (15) est choisi de manière à ce que les composantes parasites du champ magnétique, situées dans la direction de sensibilité (70) de l'élément capteur (10) qui sont générées par des courants dans la nervure de liaison (5) entre les deux branches (4) de l'élément conducteur en forme de U (2) sont minimisées à l'emplacement de l'élément capteur (10) ou que l'angle d'inclinaison (15) est choisi de manière à ce que les composantes parasites du champ magnétique résultant, situées dans la direction de sensibilité (70) de l'élément capteur (10) sont minimisées à l'emplacement de l'élément capteur (10) sachant que le champ magnétique résultant est formé par superposition du champ magnétique généré par les courants dans la nervure de liaison (5) entre les deux branches (4) de l'élément conducteur en forme de U (2), et du champ magnétique généré par les courants à travers les câbles de raccordement (3) à l'élément conducteur en forme de U (2).

4. Dispositif selon une des revendications précédentes, **caractérisé en ce que** l'élément capteur (10) est un capteur de gradient ou un capteur mesurant un champ absolu, sachant que l'élément capteur (10) est de préférence un capteur magnétorésistif.

5. Dispositif selon une des revendications précédentes, **caractérisé en ce que** l'élément conducteur coudé, de préférence en forme de U (2) est formé par des fentes (13) dans une pièce conductrice (12) plate et droite, sachant que notamment les deux branches de l'élément conducteur en forme de U sont parallèles l'une par rapport à l'autre.

6. Dispositif selon une des revendications précédentes, **caractérisé en ce qu'**est prévu au moins un moyen de fixation (8) qui accueille ledit au moins un élément capteur (10) et le fixe dans la position inclinée par rapport à l'élément conducteur en forme de U (2) associé.

7. Dispositif selon la revendication 6, **caractérisé en ce que** le moyen de fixation (8) s'encliquète dans ou sur une pièce conductrice droite (12) ou un élément conducteur en forme de U (2).

8. Dispositif selon la revendication 6, **caractérisé en ce que** le moyen de fixation (8) présente au moins une piste conductrice électrique (17) qui met en contact électrique ledit au moins un élément capteur (10).

9. Dispositif selon la revendication 6, **caractérisé en ce que** le moyen de fixation (8) est conçu selon la technique MID (Molded Interconnect Devices).

10. Dispositif selon la revendication 6, **caractérisé en ce que** des composants électroniques (9) associés audit au moins un élément capteur (10) sont disposés sur le moyen de fixation (8).

11. Dispositif selon la revendication 6, **caractérisé en ce qu'**une enveloppe protectrice (14) est prévue au moins autour du moyen de fixation (8) avec ledit au moins un élément capteur (10), sachant que l'enveloppe (14) entoure de préférence des parties de l'élément conducteur en forme de U (2).

12. Dispositif selon une des revendications précédentes, **caractérisé en ce que** la disposition spatiale tridimensionnelle de l'élément capteur (10) et de la partie de conducteur parasite lors de la mesure de courant (5, 32) se trouve l'une par rapport à l'autre de telle sorte que la direction de sensibilité (70) de l'élément capteur (10) est dirigée à angle droit d'une tangente d'une ligne de champ magnétique fermée du champ magnétique parasite généré par la répartition de courant de la partie de conducteur parasite lors de la mesure du courant (5, 32).

13. Dispositif selon la revendication 12, **caractérisé en ce que** l'élément conducteur (2) est une pièce métallique découpée et pliée (50), sachant que le centre de gravité de la répartition de la densité de courant à travers la partie de conducteur parasite lors de la mesure de courant (5, 32) et un plan d'alignement neutre par rapport au champ magnétique (40), dont la normale est à angle droit de la direction de sensibilité (70), se situent à l'emplacement de l'élément capteur (10), essentiellement sur le même plan en hauteur z.

14. Dispositif selon la revendication 12, **caractérisé en ce que** l'élément conducteur (10) est disposé sur une partie de conducteur recourbée, active lors de la mesure du courant (4, 30, 52), sachant que le centre de gravité de la répartition de la densité de courant à travers la partie de conducteur parasite lors de la mesure de courant (5, 32) et un plan d'alignement neutre par rapport au champ magnétique (40), dont la normale est à angle droit de la direction de sensibilité (70), se situent à l'emplacement de l'élément capteur (10), essentiellement sur le même plan en hauteur z.

15. Dispositif selon une des revendications 12 à 14, **caractérisé en ce que** les parties de conducteur actives et parasites lors de la mesure du courant (4, 5, 30, 32, 52) sont disposées sur ou dans une disposition PCB (Printed Circuit Board) (60), notamment dans un circuit imprimé multicouches (64) sur des couches décalées en hauteur (56).
